# EUROPEAN PATENT SPECIFICATION

(11) **EP 1 840 449 B1**
(45) Date of publication and mention of the grant of the patent: **12.03.2014**
(21) Application number: 06112034.1
(22) Date of filing: 30.03.2006
(51) Int. Cl.: E04D 3/06, G09F 13/04, A47F 11/10, A47F 3/00, C03C 17/23, F21V 33/00, F21K 99/00, B60Q 3/02, B32B 17/10, E06B 3/66

(54) **Light Panel**
Leuchtpaneel
Panneau lumineux

(43) Date of publication of application: 03.10.2007
(73) Proprietor: AGC Glass Europe, 1170 Bruxelles (Watermael-Boitsfort) (BE)
(72) Inventor: Lefevre Hugues, 6040 Jumet (BE); Luijkx Antoine, 6040 Jumet (BE)
(74) Representative: Bayot, Daisy

(56) References cited:
- EP-A- 0 900 971
- EP-A- 1 437 215
- CA-A1- 2 355 416
- DE-A1-102004 039 897
- GB-A- 2 362 022
- US-A- 3 673 664
- US-A- 4 453 669
- US-A- 4 721 845
- US-A- 4 816 649
- US-A1- 2004 040 228
- US-A1- 2005 238 857
- PATENT ABSTRACTS OF JAPAN vol. 1998, no. 02, 30 January 1998 (1998-01-30) & JP 09 282625 A (TOTOKU ELECTRIC CO LTD), 31 October 1997 (1997-10-31)

## Description

This invention relates to a panel incorporating a plurality of light emitting diodes (LEDs). Such a panel is described in document EP1437215A.

According to a first aspect, the present invention provides a panel as defined in Claim 1.

The dependent claims define features of preferred or alternative embodiments of the invention.

Other aspects of the invention are defined in other independent claims.

The panel may be a glazing panel and/or a lighting panel; it may be a shelf, a partition or a wall covering panel.

The panel may have at least three lighting circuits; it may have more than 5 or more than 10 lighting circuits; it may have less than 50 lighting circuits.

Each bus bar may prove connection to at least three lighting circuits. A bus bar can be an elongated electrically conductive element such as a wire as described in documents JP 09282625A and US A4816649.

Preferably, all of the lighting circuits of the panel are supplied with electrical power using only the two bus bars. This may greatly facilitate electrical connection of the panel.

The electrical confection of the panel may also be facilitated by having only a single position at the panel at which electrical connection to a power source is required; this may be at a corner of the panel; it may be at some other position along one edge of the panel.

An arrangement having all of the bus bars arranged along a single edge of the panel may facilitate mounting of the panel and/or hiding of the electrical connections as connections may be unnecessary at other edges of the panel.

In the case of shelves, the bus bars may be arranged along the rear edge or a side edge of the shelf and hidden by a structure used to support the shelves or mount the shelves to a wall or other supporting structure. Shelves may have a length within the range 0.75 m to 2.5m, preferably within the range 0.8 m to 1.8 m; they may have a depth within the range 15cm 80cm, preferably within the range 20 cm to 50cm.

In the case of partitions or wall cladding panels, the bas bars are preferably arranged along the bottom edge of the panel; they by thus be less conspicuous and/or easier to hide or disguise from view and/or easier to connect to an external electrical power source. Such panels may have a height within the range 0.6 m to 3.5m, preferably within the range 1.2 m to 2.5 m; they may have a width within the range 0.8m to 3.2m preferably within the range 1.2 m to 2.4m.

The electrically conducting pathways may be provided by an electrically conducting coating layer provided directly on one of the surfaces of the glass substrate. This may be a sputtered coating stack which may have a physical thickness in the range of 5 nm to 300 nm, for example a coating stack comprising ITO or silver. Alternatively, it may be a pyrolytic coating, particularly one deposited by chemical vapour deposition, which may have a thickness in the range of 100 nm to 5000 nm, for example a coating comprising tin oxide doped with fluorine or antimony. The sheet resistance of the conducting coating layer may be within the range of 1 to 6 ohms/square or within the range of 2 to 20 ohms/square.

Interruptions are provided in the conductive coating layer so as to define one or more electrical pathways; such interruptions may be provided by masking during deposition of the coating layer or by ablation, for example laser ablation, chemical etching, abrasion or cutting. Provision of the electrically conducting pathways directly on one of the surfaces of one of the glass substrate, particularly in the form of a coating layer, may facilitate cutting to size and/or handling and/or assembly.

Alternatively, the electrically conductive pathways may be provided by an electrically conductive coating layer provided on a substrate, for example a PET film, associated with the glass substrate, for example, laminated or adhered to the glass substrate. In this case, the coating layer may be a sputtered coating layer as referred to above.

The electrically conducting coating is preferably present over substantially the entire surface area of the substrate, for example over at least 90 % or 95 % of the surface area of the substrate. This may provide a substantially constant or homogeneous visual appearance over the panel.

The substrate(s) may be a glass sheet; a flat soda lime glass, notably float glass, may be used for one and preferably both of the glass sheets (when two sheets are used). One or both of the glass sheets may be clear glass, extra clear glass or body tinted glass.

Particularly when intended for use in window applications, the glazing panel may be substantially transparent. In this case, it may have a light transmission (CIE Illuminant C) of greater than or equal to 40%, 50%, 60% or 70% and/or a level of haze of less than or equally to 5%, 3% or 2%.

Particularly when intended for decoration and/or lighting purposes, it may be unnecessary and/or undesired for the panel to be substantially transparent. In this case, it may have a light transmission (CIE Illuminant C) of less than or equal to 20%, 10%, or 5% and/or a level of haze of greater than or equally to 30%, 40% or 50%.

Use of a substantially transparent electrically conductive coating layer may be preferable when some or all of the LEDs are arranged to provide illuminate that will pass through the electrically conducting pathway.

First and second glass sheets may be laminated together to form a laminated assembly by a plastics interlayer which comprises one or more sheets of PVB or a resin, for example EVA. The plastics interlayer may be substantially transparent; it may be neutral or clear in colour or it may be body tinted.

Preferably, the majority and more preferably substantially the entire surface area of the panel is provided with LEDs, that is to say that the LEDs form an array of spaced LEDs with the array covering greater than 50%, 60%, 70%, 80% or 90% of the surface area of the panel.

The panel may incorporate at least 30, 50, 100 or 200 LEDs.

The substrate(s), particularly when in the form of glass sheets preferably have a thickness within the range of 2.5 mm to 10 mm.

When the panel is a glazing panel, it may have a mechanical resistance as defined in European Standard EN12600 (often referred to as the pendulum test) of 3B3, preferably 2B2 and more preferably 1B1.

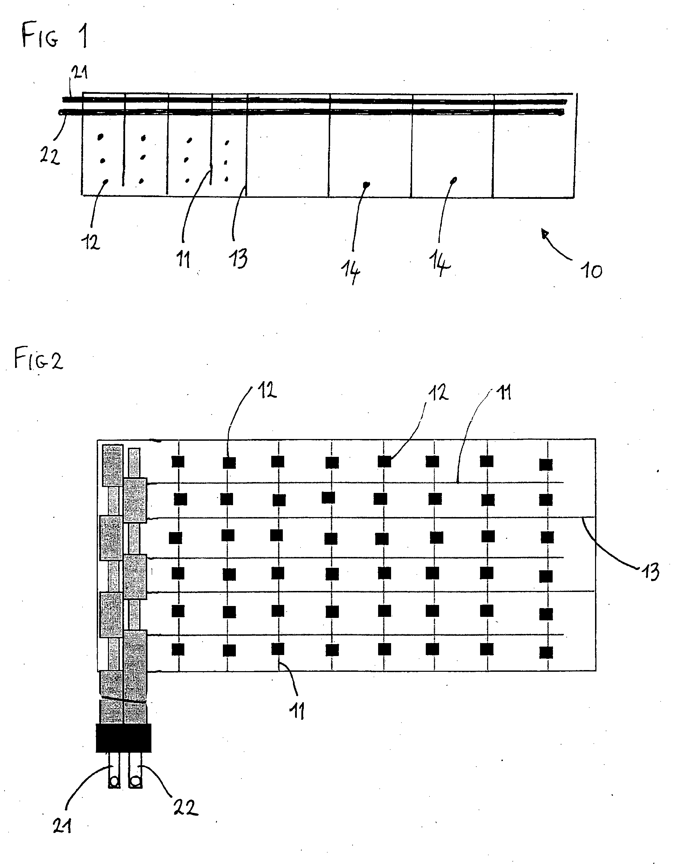

Non-limiting embodiments of the invention are described with reference to the accompanying drawings of which
Fig 1 is a schematic plan view of a panel in the form of a shelf ;
Fig 2 is a schematic plan view in more detail of a panel;
Fig 3 is a schematic plan view of part of a bus bar;
Fig 4 is a schematic cross section of part of a bus bar;
Fig 5 is a schematic plan view of an alternative form of bus bar.

A panel 10 comprises first and second flat, clear, 3mm thick soda lime float glass sheets laminated together by means of a 0.76 mm thick sheet of PVB. The inner surface of the first glass sheet is provided with a substantially colour neutral CVD coating stack comprising an SiOxCy undercoat and an overlying Sn02:F coating. The coating has a resistance of about 15 ohms per square. Interruptions 11 in the coating stack formed by laser ablations about 70 microns wide define electrically conducting pathways for LEDs 12 which are soldered or attached with an electrically conductive adhesive either side of the laser ablations 11. Each LED is in direct contact with the coating of the first glass sheet. Additional laser ablations 13 run between opposite edges of the panel to divide the panel in to sections 14 with each section containing a single lighting circuit provided by its LEDs and the pathway provided in the electrically conductive coating. The LEDs in each individual lighting circuit are connected in series.

In this embodiment, the LEDs are adapted to provide illumination through the second glass sheet i.e. without passage through or hindrance by the conductive pathways provided by the coating layer.

The LEDs are arranged in a regular grid at 5cm intervals such that the array of diodes covers substantially the entire area of glazing panel. Each LED has a surface area of about 4mm².

First and second bus bars 21, 22 extend substantially along the entire length of one edge of the panel, laminated between the two glass sheets. The bus bars project from the glazing panel at one corner for easy connection to an electrical power supply. If the lighting circuits are adapted to receive a DC supply, one bus bar will be connected to the positive and the other to the negative terminal of the supply.

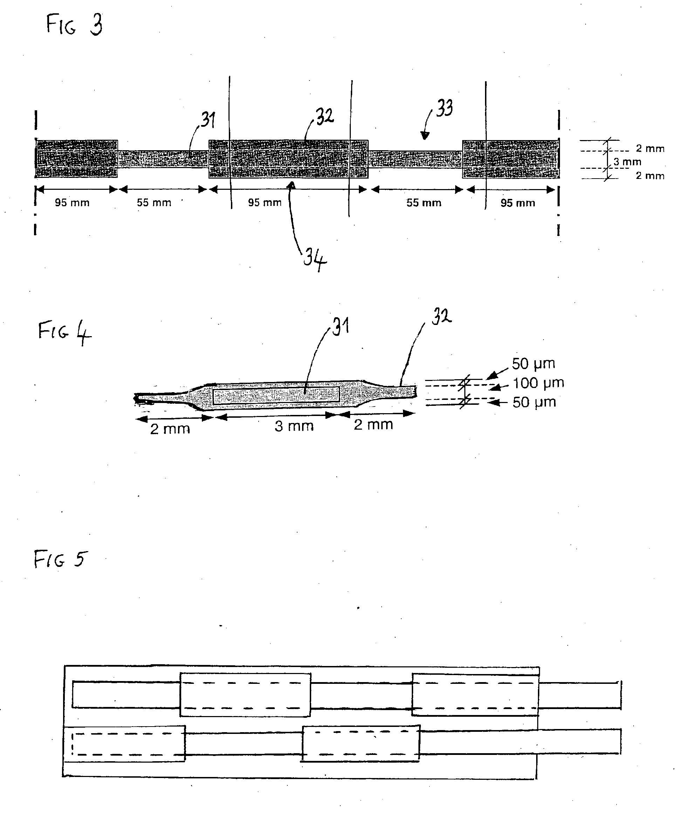

Each bus bar has a metallic copper core which may be in the order of 100 µ thick; the core may be plated with another metal, for example tin. The plating may be 2-3µ thick. At spaced intervals along the length of the bus bar, strips of plastics 31, for example of kapton, overlies each face of the metal core 31 of the bus bar. The plastics strips is wider than the metal core so they projects beyond each side edge of the core as shown in Fig 4. This forms a step in the thickness of the bas bar between its central portion and its edge portion. This may facilitate laminating of the bus bar between sheets of the panel, particularly using pvb to laminate glass sheets together. The plastic strips are glued to each other and to the metallic core by an adhesive, which may have a thickness of 15-30, preferably about 25µ.

The positioning of the plastic strips 32 along the bus bar define alternatively spaced conducting portions 33 and non conducting portions 34. The conducting portions are adapted to provide electrical connection between the bus bar and the electrically conductive coating layer of the panel. The non conduction portions are adapted to prevent electrical connection between the bus bar and the electrically conductive coating layer of the panel. The first and second bus bars are arranged so that their conduction portions are offset with respect to each other (the same is true for their non conducting portions). In this way, a plurality of U shaped lighting circuits are constituted in the panel, each lighting circuit extending from a connecting portion of one of the bas bars to an offset connection portion of the other bus bar.

The dimensions of the insulating portions of the bus bars, their positioning and the positioning of the laser ablations is arranged to avoid undesired short circuits. The positions of the non-conducting portions of the first and second bus bars may overlap with this in mind.

In an alternative embodiment the two bus bars are joined together to form a single assembly. This facilitates assembly of the bus bar with the panel. It may be achieved by joining the two bus bars together side by side, for example with an overlying adhesive tape on a side of the bus bars which is not intended to be in electrical contact with the electrically conductive coating, or as illustrated in Fig 5, assembling the two bas bars side by side on a continuous plastics strip 51 which is wider that the combined width of the two bus bars, and providing insulation portions 52 on the other side of the bus bar, the insulating portions 52 for the first bas bar being spaced or offset with respect to those of the second bus bar.

Substrates other than glass may be used in respect of any aspect of the invention.

## Claims

1. A panel comprising:
a glass substrate;
an electrically conductive coating layer;
a plurality of LEDs arranged in series,
**characterized in that** the panel also comprises a plurality of lighting circuits provided by pathways defined within the electrically conductive coating layer and the plurality of LEDs arranged in series
first and second, spaced electrical bus bars, each bus bar extending along the same edge of the panel, each bus bar being adapted to provide electrical power to a plurality of lighting circuits.

2. A panel in accordance with claim 1, in which each lighting circuit follows a substantially u-shaped path between the first and the second bus bar.

3. A panel in accordance with claim 1 or claim 2, in which each bus bars extend substantially along the entire length of the edge of the panel.

4. A panel in accordance with any preceding claim, in which each lighting circuit comprises at least 4 LEDs arranged in series.

5. A panel in accordance with any preceding claim, in which each bus bars comprise an electrically conductive core and an electrical insulator preventing contact between the electrically conductive core and the electrically conductive coating at selected positions.

6. A panel in accordance with claim 5, in which the electrically conductive core is a metallic strip.

7. A panel in accordance with claim 6, in which each bus bar comprises a plurality of spaced insulators arranged at intervals along its length so as to provide alternating connecting and non-connecting portions.

8. A panel in accordance with any claim 7, in which the connecting portions of the first bus bar are offset in position along the edge of the panel with respect to the connecting portions of the second bus bar.

9. A panel in accordance with any preceding claim, in which the electrically conductive coating layer is substantially transparent.

10. A panel in accordance with any preceding claim, in which the electrically conductive coating is deposited directly on the surface of the glass substrate.

11. A panel in accordance with any preceding claim, in which the glazing panel comprises a second substrate, spaced from the first substrate so that the LEDs are positioned between the two substrates.

12. A panel in accordance with claim 11, in which the second substrate is a glass sheet, spaced from the first substrate with an intervening gas filled space.

13. A panel in accordance with claim 11, in which the second substrate is a glass sheet and in which the two glass substrates are laminated together via a plastics interlayer, preferably comprising a layer of pvb.

14. A panel in accordance with claim 13, in which the bus bars are adapted to be laminated between the two glass substrate, to form part of the panel.

15. A panel in accordance with any one of claims 1 to 14, in which the maximum thickness of the bus bars is less than 500µ, preferably less than 300 µ.

16. A panel in accordance with any preceding claim, in which the panel is selected from a glazing panel, a lighting panel, a shelf, a partition, a wall panel.

17. A panel in accordance with anyone of claims 7 to 14, in which the spaced insulators are provided by plastics strips which overlie the metallic core.

18. A panel in accordance with anyone of claims 7 to 15, in which each insulator insulates both sides of the metallic strip.

## Patentansprüche

1. Paneel, das umfasst:
ein Glassubstrat;
eine elektrisch leitende Überzugsschicht;
eine Vielzahl von in Reihe angeordneten LEDs,
**dadurch gekennzeichnet, dass** das Paneel auch eine Vielzahl von Beleuchtungsschaltungen, die durch Leitungen innerhalb der elektrisch leitenden Überzugsschicht definiert sind, und die Vielzahl von in Reihe angeordneten LEDs umfasst,
erste und zweite beabstandete elektrische Sammelleiter, wobei jeder Sammelleiter sich entlang des gleichen Rands erstreckt, wobei jeder Sammelleiter geeignet ist, elektrische Leistung an eine Vielzahl von Beleuchtungsschaltungen zu liefern.

2. Paneel gemäß Anspruch 1, wobei jede Beleuchtungsschaltung einem im Wesentlichen u-förmigen Weg zwischen der ersten und zweiten Sammelleitung folgt.

3. Paneel nach Anspruch 1 oder Anspruch 2, wobei jede Sammelleitung sich im Wesentlichen entlang der gesamten Länge des Rands des Paneels erstreckt.

4. Paneel nach jedem vorhergehenden Anspruch, wobei jede Beleuchtungsschaltung wenigstens 4 in Reihe angeordnete LEDs umfasst.

5. Paneel nach jedem vorhergehenden Anspruch, wobei jede Sammelleitung einen elektrisch leitfähigen Kern und einen elektrischen Isolator umfasst, der den Kontakt zwischen dem elektrisch leitfähigen Kern und dem elektrisch leitfähigen Überzug an ausgewählten Positionen verhindert.

6. Paneel gemäß Anspruch 5, wobei der elektrisch leitfähige Kern ein metallischer Streifen ist.

7. Paneel nach Anspruch 6, wobei jede Sammelleitung eine Vielzahl von beabstandeten Isolatoren umfasst, die entlang ihrer Länge in Abständen angeordnet sind, um abwechselnd verbindende und nicht verbindende Abschnitte bereitzustellen.

8. Paneel nach Anspruch 7, wobei die verbindenden Abschnitte der ersten Sammelleitung in der Position entlang des Rands des Paneels in Bezug auf die verbindenden Abschnitte der zweiten Sammelleitung versetzt sind.

9. Paneel nach Anspruch nach jedem vorhergehenden Anspruch, wobei die elektrisch leitende Überzugsschicht im Wesentlichen transparent ist.

10. Paneel nach jedem vorhergehenden Anspruch, wobei der elektrisch leitende Überzug direkt auf der Oberfläche des Glassubstrats aufgetragen ist.

11. Paneel nach jedem vorhergehenden Anspruch, wobei das glasierte Paneel ein zweites Substrat umfasst, das von dem ersten Substrat beabstandet ist, so dass die LEDs zwischen den zwei Substraten positioniert sind.

12. Paneel nach Anspruch 11, wobei das zweite Substrat eine Glasschicht ist, die von dem ersten Substrat durch einen dazwischen kommenden gasgefüllten Raum beabstandet ist.

13. Paneel nach Anspruch 11, wobei das zweite Substrat eine Glasschicht ist, in der die zwei Glassubstrate über eine Kunststoffzwischenschicht, die vorzugsweise eine Schicht aus PVB umfasst, aneinander laminiert sind.

14. Paneel nach Anspruch 13, wobei die Sammelleitungen geeignet sind, zwischen die zwei Glassubstrate laminiert zu werden, um einen Teil des Paneels zu bilden.

15. Paneel nach einem der Ansprüche 1 bis 14, wobei die maximale Dicke der Sammelleitungen weniger als 500 □, vorzugsweise weniger als 300 □ ist.

16. Paneel nach jedem vorhergehenden Anspruch, wobei das Paneel aus einem glasierten Paneel, einem Beleuchtungspaneel, einem Brett, einer Trennwand, einer Wandtafel ausgewählt ist.

17. Paneel nach einem der Ansprüche 7 bis 14, wobei die beabstandeten Isolatoren durch Kunststoffstreifen, die den Metallkern überlagern, bereitgestellt sind.

18. Paneel nach einem de Ansprüche 7 bis 15, wobei jeder Isolator beide Seiten des metallischen Streifens isoliert.

## Revendications

1. Un panneau comprenant :
un substrat en verre ;
une couche de revêtement électriquement conductrice ;
une pluralité de LED disposés en série,
**caractérisé en ce que** le panneau comprend également une pluralité de circuits d'éclairage fournis par des chemins définis à l'intérieur de la couche de revêtement électriquement conductrice et de la pluralité de LED disposés en série une première et une seconde barres omnibus électriques espacées, chaque barre omnibus s'étendant le long du même bord du panneau, chaque barre omnibus étant adaptée pour délivrer de l'énergie électrique à une pluralité de circuits d'éclairage.

2. Un panneau selon la revendication 1, dans lequel chaque circuit électrique suit un trajet substantiellement en forme de U entre la première et la seconde barre omnibus.

3. Un panneau selon la revendication 1 ou la revendication 2, dans lequel chaque barre omnibus s'étend substantiellement le long de la longueur totale du bord du panneau.

4. Un panneau selon l'une quelconque des revendications précédentes, dans lequel chaque circuit d'éclairage comprend au moins 4 LED disposés en série.

5. Un panneau selon l'une quelconque des revendications précédentes, dans lequel chaque barre omnibus comprend un noyau électriquement conducteur et un isolateur électrique empêchant le contact entre le noyau électriquement conducteur et le revêtement électriquement conducteur en des positions sélectionnées.

6. Un panneau selon la revendication 5, dans lequel le noyau électriquement conducteur est une bande métallique.

7. Un panneau selon la revendication 6, dans lequel chaque barre omnibus comprend une pluralité d'isolateurs espacés disposés à intervalles le long de sa longueur de manière à fournir des portions de connexion et de non-connexion alternées.

8. Un panneau selon la revendication 7, dans lequel les portions de connexion de la première barre omnibus sont en position décalée le long du bord du panneau par rapport aux portions de connexion de la seconde barre omnibus.

9. Un panneau selon l'une quelconque des revendications précédentes, dans lequel la couche de revêtement électriquement conductrice est substantiellement transparente.

10. Un panneau selon l'une quelconque des revendications précédentes, dans lequel le revêtement électriquement conducteur est déposé directement sur la surface du substrat en verre.

11. Un panneau selon l'une quelconque des revendications précédentes, dans lequel le vitrage comprend un second substrat, espacé du premier substrat de sorte que les LED soient positionnés entre les deux substrats.

12. Un panneau selon la revendication 11, dans lequel le second substrat est une feuille de verre, espacée du premier substrat par un espace intermédiaire rempli de gaz.

13. Un panneau selon la revendication 12, dans lequel le second substrat est une feuille de verre et dans lequel les deux substrats en verre sont feuilletés ensemble à l'aide d'une couche intermédiaire en matière plastique, comprenant de préférence une couche de PVB.

14. Un panneau selon la revendication 13, dans lequel les barres omnibus sont adaptées pour être laminées entre les deux substrats en verre de manière à faire partie du panneau.

15. Un panneau selon l'une quelconque des revendications 1 à 14, dans lequel l'épaisseur maximum des barres omnibus est inférieure à 500µ, de préférence inférieure à 300µ.

16. Un panneau selon l'une quelconque des revendications précédentes, dans lequel le panneau est sélectionné parmi un vitrage, un panneau d'éclairage, une étagère, une cloison, un panneau mural.

17. Un panneau selon l'une quelconque des revendications 7 à 14, dans lequel les isolateurs espacés sont fournis par des bandes en plastique qui recouvrent le noyau métallique.

18. Un panneau selon l'une quelconque des revendications 7 à 15, dans lequel chaque isolateur isole les deux côtés de la bande métallique.
